# FASCICULE DE BREVET EUROPEEN

(11) **EP 2 834 305 B1**
(45) Date de publication et mention de la délivrance du brevet: **11.07.2018**
(21) Numéro de dépôt: 13719975.8
(22) Date de dépôt: 03.04.2013
(51) Int. Cl.: C08L 65/00, C08K 3/04, C08K 7/06, C08K 7/24

(54) **COPOLYMERES A BLOC DISPERSANTS DE NANOCHARGES DANS L' EAU**
BLOCKCOPOLYMEREN ZUR DISPERSION VON NANOFILAMENTEN IN WASSER
BLOCK COPOLYMERS THAT DISPERSE NANOFILLERS IN WATER

(30) Priorité: 06.04.2012 FR 1253228
(43) Date de publication de la demande: 11.02.2015
(73) Titulaire: Arkema France, 92700 Colombes (FR); Centre National de la Recherche Scientifique, 75794 Paris Cedex 16 (FR); Université de Bordeaux 1, 33405 Talence (FR)
(72) Inventeur: NAVARRO, Christophe, F-64100 Bayonne (FR); BETHANI, Katerina, F-33000 Bordeaux (FR); BROCHON, Cyril, F-33700 Merignac (FR); CRAMAIL, Henri, F-33350 Sainte-Terre (FR); FLEURY, Guillaume, F-33000 Bordeaux (FR); HADZIIOANNOU, Georges, F-33850 Leognan (FR); CLOUTET, Eric, F-33880 Saint Caprais De Bordeaux (FR)
(74) Mandataire: Schaefer, Anne-Sophie
(86) Numéro de dépôt international: PCT/FR2013/050734
(87) Numéro de publication internationale: WO 2013/150242

(56) Documents cités:
- WO-A2-2009/086210
- US-A1- 2009 118 420
- JIANHUA ZOU ET AL: "A general strategy to disperse and functionalize carbon nanotubes using conjugated block copolymers", ADVANCED FUNCTIONAL MATERIALS, WILEY - V C H VERLAG GMBH & CO. KGAA, DE, vol. 19, no. 3, 10 février 2009 (2009-02-10), pages 479-483, XP001520301, ISSN: 1616-301X, DOI: 10.1002/ADFM.200800542
- NICOLAS SARY ET AL: "A New Supramolecular Route for Using Rod-Coil Block Copolymers in Photovoltaic Applications", ADVANCED MATERIALS, vol. 22, no. 6, 9 février 2010 (2010-02-09), pages 763-768, XP055047208, ISSN: 0935-9648, DOI: 10.1002/adma.200902645
- KUAN-KAI HUANG ET AL: "Synthesis, micellar structures, and multifunctional sensory properties of poly(3-hexylthiophene)-block-poly(2-(dimet hylamino)ethyl methacrylate) rod-coil diblock copolymers", JOURNAL OF POLYMER SCIENCE PART A: POLYMER CHEMISTRY, vol. 49, no. 1, 1 janvier 2011 (2011-01-01), pages 147-155, XP055047312, ISSN: 0887-624X, DOI: 10.1002/pola.24429
- LEI ZHAI: "Conjugated Polymer/Carbon Nanotube Composites", PMSE PREPRINTS, vol. 103, 22 août 2010 (2010-08-22), pages 605-606, XP009165561, US
- STOKES PAUL ET AL: "Photoresponse in large area multiwalled carbon nanotube/polymer nanocomposite films", APPLIED PHYSICS LETTERS, AIP, AMERICAN INSTITUTE OF PHYSICS, MELVILLE, NY, US, vol. 94, no. 4, 30 janvier 2009 (2009-01-30), pages 42110-42110, XP012118756, ISSN: 0003-6951, DOI: 10.1063/1.3075957
- ZHENZHONG SUN ET AL: "PS-b-P3HT Copolymers as P3HT/PCBM Interfacial Compatibilizers for High Efficiency Photovoltaics", ADVANCED MATERIALS, vol. 23, no. 46, 8 décembre 2011 (2011-12-08), pages 5529-5535, XP055047205, ISSN: 0935-9648, DOI: 10.1002/adma.201103361
- SANG WON KIM ET AL: "Surface modifications for the effective dispersion of carbon nanotubes in solvents and polymers", CARBON, ELSEVIER, OXFORD, GB, vol. 50, no. 1, 10 août 2011 (2011-08-10), pages 3-33, XP028307789, ISSN: 0008-6223, DOI: 10.1016/J.CARBON.2011.08.011 [extrait le 2011-08-16]

## Description

L'invention concerne de nouveaux copolymères à blocs, permettant une bonne dispersion de nanocharges dans l'eau. L'invention concerne également une dispersion de nanocharges obtenue grâce aux copolymères à bloc de l'invention ainsi que son utilisation comme électrodes transparentes dans les cellules solaires organiques ou autres dispositifs photo émetteurs ou photo récepteurs.

Dans les systèmes photovoltaiques et photo émetteurs ou photo récepteurs, il est nécessaire d'utiliser des couches conductrices transparentes. Les matériaux généralement utilisés sont des oxydes conducteurs, tels que l'oxyde d'indium dopé à l'étain. Ce matériaux présente l'avantage d'être transparent, bon conducteur électrique, facile à mettre en forme et est chimiquement stable. En revanche, il est difficile à fabriquer donc onéreux. En outre son procédé de fabrication est générateur de produits polluants.

Il est donc recherché des nouveaux matériaux, présentant les avantages de l'oxyde d'indium dopé à l'étain, sans ses inconvénients. Des alternatives utilisées pour contourner les problèmes de fabrication de l'oxyde d'indium dopé à l'étain consistent à l'associer à d'autres oxydes tels que l'oxyde de zinc, ou d'étain. D'autres solutions utilisent des matériaux exempts d'indium, tels que l'oxyde de zinc dopé avec l'aluminium ou le gallium à ou encore l'oxyde de zinc dopé fluor sans être de bonnes solution car ils présentent d'autres désavantages tels que leur stabilité électrique en environnement humide. Ces désavantages sont décrits dans l'article de Tadatsugu, M., Thin Solid Films, (516) 1314, (2008).
Par ailleurs, les polymères conducteurs ont été testés comme matériaux d'électrodes transparentes. On peut citer les formulations PEDOT :PSS (poly(3,4-éthylènedioxythiophène) : poly(styrène sulfonate) de sodium) comme prometteuses car elles combinent une bonne conductivité (29.6 S/cm) et une bonne habilité à la filmification. En revanche, leur stabilité électrique est sensible aux hautes températures, à l'humidité et aux rayonnements ultraviolets tel que décrit par Xue, F et al, Electron Devices, IEEE Transactions on (9) 1982 (2005).

En raison du large besoin pour disposer d'électrodes transparentes, d'autres matériaux sont à l'étude pour remplacer en particulier l'oxyde d'indium dopé à l'étain notamment dans les applications de cellules solaires. On peut citer les films conducteurs à base de nano fils d'argent, les films minces métalliques, les films de nanotubes ou les films de graphène comme candidats potentiellement prometteurs. Concernant plus particulièrement les nanotubes de carbone, ils peuvent avoir deux types d'application dans les cellules solaires, premièrement en tant que couche active ou ils peuvent jouer le rôle de semi conducteurs, deuxièmement en tant qu'électrode.
Les nanotubes de carbone sont les matériaux parmi les plus prometteurs. Ils sont considérés comme le résultat du repliement de feuillets de graphite en cylindres ou tubes de carbone. Ils existent sous différentes formes selon le nombre de parois : mono-paroi, double-parois, ou multi-parois. Selon, l'angle de repliement et le diamètre des tubes on obtient des états électroniques semi-conducteurs ou métalliques. Les nanotubes de carbones sont maintenant bien connus pour leurs propriétés électriques, mécaniques et optiques extraordinaires. La haute conductivité des nanotubes de carbone dépend de plusieurs paramètres dont leur degré de dispersion.
Plusieurs méthodes sont connues pour obtenir une bonne dispersion de nanotubes de carbone, telles que l'utilisation de tensioactifs, l'utilisation de nanotubes de carbone fonctionnalisés combinée à des polymères dispersants ou d'autres dispersants tels que l'ADN, les protéines ou l'amidon. Ces dispersants doivent être ultérieurement enlevés une fois le film formé par un traitement spécifique car ils sont isolants électriques. L'enrobage des nanotubes de carbone par des polymères est une méthode classique pour assurer leur bonne dispersion. Les polymères se lient à la surface des nanotubes de carbone par des intéractions π-π, ce qui préserve les propriétés intrinsèques des nanotubes de carbone. Ce sont typiquement des polymères conjugués ou des polymères contenant des entités pyrène (Zhu, J. et al. Journal of the American Chemical Society (133)7450, (2011). On peut aussi bien utiliser des homopolymères que des copolymères à bloc.
Jusqu'à présent il n'existe pas de solution pour convenablement disperser les nanotubes de carbone en milieu aqueux, appliquer cette dispersion pour en faire un film de bonne qualité, et ne nécessitant pas de traitement postérieur.

La demanderesse à maintenant découvert que les copolymères à blocs, dont au moins un des blocs est un polymère conducteur conjugué et au moins un des blocs est un poly-électrolyte permettent une bonne dispersion des nanocharges dans l'eau, cette dispersion présentant de bonnes qualités de filmification. Les films obtenus présentent de bonnes propriétés applicatives, ne nécessitent pas de post traitement. Ils sont aussi bien conducteurs électriques que conducteurs ioniques.

### Résumé de l'invention :

L'invention concerne une composition comprenant au moins un copolymère à blocs soluble ou présentant une dispersion stable dans l'eau et présentant au moins un bloc constitué d'un polymère conjugué et au moins un bloc constitué d'un polymère poly-électrolyte de type styrène-styrène sulfonate.

### Description détaillée :

Par dispersion stable, on entend une dispersion qui ne présente pas de sédimentation et qui reste homogène pendant au moins une semaine.

Par copolymère à blocs on entend les copolymères di-blocs, tri-blocs, ou multi-blocs ou leur mélange, incluant l'homopolymère de chacun des blocs. De préférence il s'agit d'un copolymère di-blocs ou tri-blocs, et de façon encore préférée il s'agit d'un copolymère di-blocs.

S'agissant du ou des blocs constitués de polymères conjugués, il peut s'agir de tout type de polymères présentant des conjugaisons de type π. On peut citer les polymères issus du fluorène, du phénylène, de la quinoléine, du carbazole, de l'aniline, du thiophène, ou de leurs dérivés. De préférence, il s'agit des dérivés du thiophène, plus particulièrement des 3-alkyle-thiophènes, et encore plus particulièrement du 3-hexyl-thiophène.

Les blocs constitués de polymères conjugués présentent une masse moléculaire en poids comprise entre 1000 et 50000 g /mole, et de préférence entre 2000 et 10000 g/mole, avec un indice de dispersité (Ip ou Ð) supérieur à 1.

S'agissant du ou des blocs constitués de polymères électrolytes, il peut s'agir de tout polyélectrolyte, parmis lesquels on peut citer les polystyrènes sulfonates, de poly(styrène co styrène sulfonate) les polyacryliques acides, les polymères et copolymères porteurs de groupements de type bis-sulfonimide, les polymères et copolymères porteurs de groupements de type sulfonate, les polymères et copolymères porteurs de groupements de type phosphonate, le polyéthylène imine, les poly(4-vinyl pyridine)s et poly(2-vinyl pyridine)s, les poly(méth)acrylates d'aminoalkyles, de préférence les polymères électrolytes de type polyanions, et préférentiellement les polysulfonates.

De préférence, il s'agit de poly(styrène co styrène sulfonate).

Les copolymères à blocs de l'invention peuvent être préparés par toute technique adaptée. Il s'agit en particulier d'utiliser des techniques qui permettent de contrôler le nombre de blocs, leur ratio, leur longueur, ainsi que leur dispersité.
Concernant les blocs constitués de polymères conjugués il peut s'agir de blocs obtenus à bases de monomères de fluorène, phénylène, quinoléine, carbazole, de aniline ,thiophènes ou de leurs dérivés. On peut citer par exemple le 3-hexyl-thiophène. Concernant plus particulièrement le poly(3-hexyl-thiophène), il est avantageusement synthétisés par des réactions de polymérisation en métathèse de grignard telles que décritent par Loewe, R. S. et al. Macromolecules (13) 4324, (2001). Par ailleurs ces blocs peuvent être modifiés mono ou di-fonctionnels tel que décrit par Jeffries-El et al. Advanced Materials (12) 1017 (2004) et ainsi procurer une fonction permettant le départ de la polymérisation du bloc poly-électrolyte ou de son précurseur.

Dans le cas précis du poly(3-hexyl-thiophène), une fonctionnalisation de type hydroxy permet d'amorcer la polymérisation d'un monomère par la technologie RAFT (reversible addition fragmentation chain transfert). On peut par exemple y polymériser un monomère présentant une double liaison de façon contrôlée, qu'il soit ionique ou non, et ainsi obtenir le copolymère à bloc souhaité polymère conducteur-polymère ionique. On peut aussi utiliser toute autre technique de couplage et de polymérisation permettant d'obtenir ce type de structure.
Tout type de monomère présentant une double liaison peut ainsi être utilisé. On peut citer notamment les monomères le butadiène, le cyclohexadiène ou l'isoprène combinée à d'autres monomères, notamment des vinyl-aromatiques choisis parmi le styrène, l'alpha-méthyl styrène, le para méthyl styrène, le vinyl naphtalène, la vinyl 2-pyridine, la vinyl 4-pyridine ou des acrylates ou méthacrylates tels que le méthacrylate ou l'acrylate de méthyle, d'éthyle, de n-propyle, d'isopropyle, de n-butyle, d'isobutyle, de sec-butyle, de tert-butyle, de n-amyle, d'isoamyle, de n-hexyle, de cyclohexyle, de 2-éthyl hexyle, d'octyle, d'isooctyle, de décyle, de pentadécyle, de dodécyle, d'isobornyle de phényle, de benzyle, de glycidyle, de norbornyle, de lauryle, de stéaryle, de phénoxyéthyle, de 2-hydroxyéthyle, de 2-méthoxyéthyle, de 2,2,2-trifluoroéthyle ; le méthacrylonitrile, l'acrylonitrile et les dialkylméthacrylamides, les dialkylacrylamides, l'acide 2-acrylamido - 2 methyle propane sulfonique, ou une combinaison de ces monomères fonctionnalisés ou non ou pouvant être ultérieurement fonctionnalisés ou partiellement fonctionnalisés. De préférence, il s'agit de styrène, styrène sulfonate ou une combinaison styrène-styrène sulfonate. Concernant les caractéristiques des blocs constitués de polymères polyélectrolytes, ils présentent une masse moléculaire en poids comprise entre 1000 et 500000 g /mole, et de préférence entre 2000 et 50000 g/mole, avec indice de dispersité (Ip ou Ð) supérieur à 1.
L'invention concerne également l'utilisation des copolymères de l'invention comme dispersant de nanocharges dans les milieux aqueux. Par nanocharges, il s'agit sans limitation de graphènes, de fullerènes, de nanotubes de carbone ou de leur combinaison. De préférence il s'agit de nanotubes de carbone. Les nanotubes de carbone utilisés sont du type mono paroi ou multi-paroi. De préférence il s'agit de nanotubes de carbone multi-paroi.
Les dispersions sont obtenues en mélangeant une solution aqueuse de nanotubes dans l'eau à une solution aqueuse du copolymère à blocs. Pour obtenir une bonne dispersion chaque solution est préalablement traitée à l'aide d'un dispositif adéquat, par exemple par sonification.
L'invention concerne également l'utilisation films obtenus à l'aide des dispersions des copolymères à blocs et des nanocharges comme électrodes transparentes dans les cellules solaires organiques ou autres dispositifs photo émetteurs ou photo récepteurs.

On a pu vérifier la bonne conductivité électrique de ces systèmes ainsi que leurs bonnes propriétés optiques et de stabilité thermique, aux UV, à l'humidité.

### Exemple 1 (invention):

### Synthèse d'un copolymère à bloc Poly(3-hexyl-thiophène) - Poly(styrène co styrène sulfonate).

a) Synthèse du bloc Poly(3-hexyl-thiophène) Dans un ballon de 500 ml séché sous vide et munit d'une agitation et purgé à l'argon, on introduit 50 ml de tetrahydrofurane (THF) fraichement distillé, on introduit 7 g de 2'5-dibromo-3-hexylethiophène et 10.7 ml de chlorure de tertio butyle magnésium. La réaction est complétée en 3 heures à température ambiante. On additionne ensuite 150 ml de THF fraichement distillé et 0.3628 g de [1,3-bis(diphenylphosphino)propane]dichloronickel(II) Ni(dppp)Cl2, tout en maintenant l'agitation 40 min. 8.64 ml de bromure d'allyle magnésium sont ensuite ajoutés. Après évaporation du solvant sous vide, on précipite le polymère avec un éxcès de méthanol. Le polymère est ensuite purifier à l'aide d'un soxhlet durant trois jours avec du méthanol et deux jours avec du chloroforme. On mesure la masse moléculaire en nombre pas SEC étalonnée avec des échantillons de polystyrène qui s'établie) 4522 g/mole. La dispersité est de 1,1.
b) Fonctionnalisation du bloc Poly(3-hexyl-thiophène) Dans un ballon de 500 ml séché sous vide et munit d'une agitation et purgé à l'argon, on introduit 120 ml de tetrahydrofurane (THF) fraichement distillé. On introduit dans le ballon 1.4 g du polymère préparé en a) et 1.75 ml de 9-borabicyclo[3.3.1]nonane (9-BBN). La solution est ensuite laissée 24 h sous agitation à 45°C, puis est refroidit à température ambiante, suivi d'une addition de 1.21 ml d'eau oxygénée à 30 % dans de l'eau. LE mélange est à nouveau chauffé à 45°C durant 24h sous agitation. Le polymère est ensuite précipité dans le méthanol.
c) Synthèse de l'agent RAFT macro-initiateur. Dans une solution d'hydroxyde de potassium (13g, 2 équivalents), on ajoute 10ml (1 équivalent) d'acide 3- mercapto-propionique. On additionne ensuite 15 ml de disulfure de carbone puis on laisse la réaction 5 h sous agitation ? à température ambiante. On additionne ensuite à cette solution 27.4 ml de bromure de benzyle et on laisse sous agitation à 80°C pendant 12 h. Le mélange réactionnel est ensuite refroidit à température ambiante et additionné de 150 ml de chloroforme puis est acidifié avec de l'acide chlorhydrique jusqu'à apparition d'une couleur jaune du mélange réactionnel. La phase aqueuse du mélange est extraite au chloroforme. On y soutire la phase organique qui est séchée sur sulfate de magnésium. Le produit final est purifié par chromatographie flash avec un mélange 3 :1 heptane-acétate d'éthyle pour finalement obtenir une poudre jaune.
d) Synthèse du macro-initiateur RAFT.
   Dans un ballon de 100 ml séché sous vide et munit d'une agitation et purgé à l'argon, on introduit 20 ml de dichlorométhane fraichement distillé on ajoute 1 g du polymère préparé à l'étape b). La solubilisation est effectuée en chauffant le mélange à 45°C. On ajoute ensuite 0.125g de l'agent RAFT préparé à l'étape c) suivi de 0.03g de 4- toluène sulfonate de 4-(diméthyle-amino)pyridinium et 0.09 ml de N,N'-diisopropyle-carbodiimide. Le mélange obtenu est laissé durant 3 jours à 30°C sous agitation. LE polymère est ensuite précipité dans le méthanol.
e) Polymérisation du styrène avec le macro-initiateur RAFT. Dans un ballon de 100 ml, on introduit 1 g du macro-initiateur RAFT obtenu à l'étape d) et 5 ml de styrène sous agitation. Le mélange est porté à 45°C pour facilité une bonne homogénéisation du milieu. Après un inertage à l'argon la température est portée à 120°C et le mélange est maintenu à cette température sous agitation pendant 4 h. Le mélange obtenu est refroidi en plongeant le ballon dans de l'azote liquide. Le copolymère à bloc obtenu est caractérisé pas SEC et présente une Mn de 49755 g/mole et une dispersité de 1.2 (Mn(PS) de 14000g/mol. est déterminée par RMN du proton).
f) Sulfonation du copolymère à bloc obtenu en e) Dans un ballon de 50 ml on introduit 3ml de dichloroéthane et 2 ml d'anhydride acétique. Cette solution (1) maintenue sous argon est refroidie à 0°C dans un bain de glace est additionnée de 0.88 ml d'acide sulfurique à 96%.
   Parallèlement, dans un ballon de 100 ml, on introduit sous inertage d'argon 20 ml de dichloro éthane. On y ajoute 1.5 g du copolymère préparé en e). Cette solution est chauffée à 45°C pour faciliter la dissolution du copolymère. On y introduit ensuite graduellement, toujours sous argon la (1). Ce mélange réactionnel est laissé sous reflux pendant 2 jours, puis 3 jours à température ambiante en fonction du degré de sulfonation souhaité. Un solide bleu noir , insoluble est alors formé. On additionne 2 ml de propanol 2 et le tout est filtré pour isoler le polymère. On mesure par RMN un taux de sulfonation de 60 % des entités styrène.

### Exemple 2 (invention): :

### Caractérisation physico chimique du copolymère.

Les solutions aqueuses de copolymères sont obtenues sous agitation à 100 °C durant 24h pour des concentrations supérieures à 0.2g/l. Pour les concentrations inférieures à 0.2g/l, on procède par dilution.

Le comportement micellaire du copolymère à bloc a pu être vérifié en mesurant la conductivité à différentes concentration. Le changement de pente correspondant à la concentration micellaire critique à pu être déterminé à une concentration de 0.02g/l (1.1 10⁻⁶ mol/l), voir le graphique 1.

La nature micellaire de la solution a par ailleurs été évaluée en mesurant le potentiel Zeta à des concentrations en dessous et au dessus de la concentration micellaire critique. Dans les deux cas, on mesure des agrégats chargés négativement, ce qui nous permet de conclure que le copolymère est auto-assemblé avec le P3HT au centre et le PS co PSS en couronne (graphique 2).

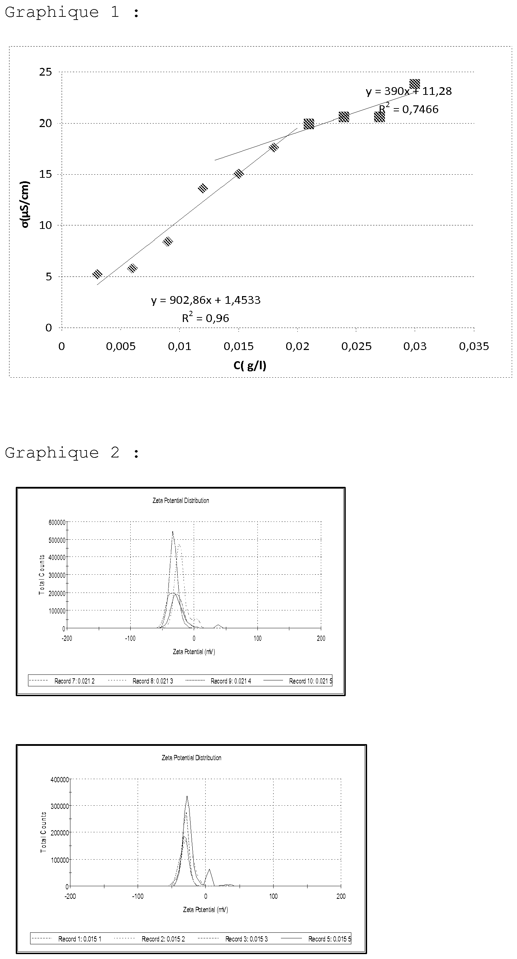

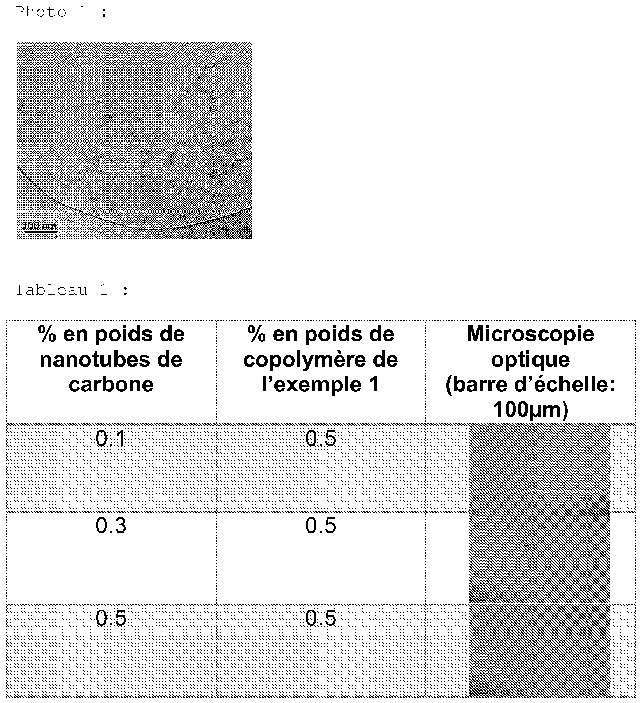

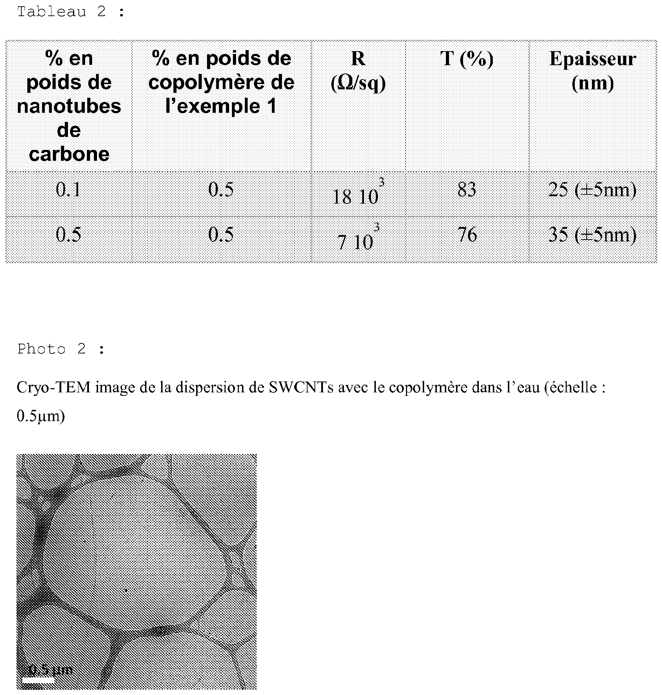

La formation d'agrégats micellaires est par ailleurs attestée par l'image de microscopie à transmission, prise sur un échantillon de solution à 0.3g/l de copolymère cryogéné (photo 1).

### Exemple 3 (invention):

### Dispersion de nanotubes de carbone multi-paroi.

La dispersion de nanotubes de carbone dans l'eau en présence du copolymère à bloc de l'invention est effectuée à l'aide d'un sonificateur, d'une puissance de 950 watts, durant 10 minutes avec des pulses 02/02 et une puissance finale de 285 dans un bain d'eau à température ambiante.

On prépare préalablement 2ml de solution aqueuse à 0.5 % en poids du copolymère de l'invention par sonification durant 5 min dans les conditions décrites ci-dessus. On additionne ensuite des quantités graduelles de nanotubes de carbone multi-paroi (Provenance Arkema), de 0.005g jusqu'à 0.05g. On observe des dispersions stables pour des concentrations jusqu'à 0.05% de nanotubes de carbone multi-paroi et 0.5 % du copolymère de l'invention dans 5 ml d'eau. Les dispersions sont caractérisées par microscopie optique (tableau 1).

### Exemple 4 (invention): :

### Formation de film et caractérisation.

Les films sont préparés en utilisant les dispersions de l'exemple 3 sur des surface en verre par la technique « doctor blade ». On caractérise ensuite les films par la transmitance dans la plage de longueur d'onde 400-800 nm (avec un appareil Shimadzu UV-VIS-NIR spectrophotometer (UV-3600)), et par leur résistivité (avec un appareil Jandel, modèle RM3-AR). On caractérise également l'épaisseur (en nanomètres) du film formé (avec un appareil Profilomètre, Alpha-Steo IQ).

Les résultats sont donnés au tableau 2.

### Exemple 5 (invention):

Des nanotubes de carbone mono-paroi fonctionnalisés (Carbon solution Inc.) sont purifiés à l'acide nitrique et dispersés avec la même technique que dans l'exemple 3.
On effectue une photo en microscopie à transmission sur un échantillon cryobroyé. On observe sur la photo 2 une bonne dispersion des nanotubes de carbone. Par ailleurs le traitement utilisé pour disperser les nanotubes de carbone n'a pas affecté leur longueur. Les petites particules noires observées sont des résidus catalytiques de la synthèse de nanotubes de carbone.

### Exemple 6 (invention):

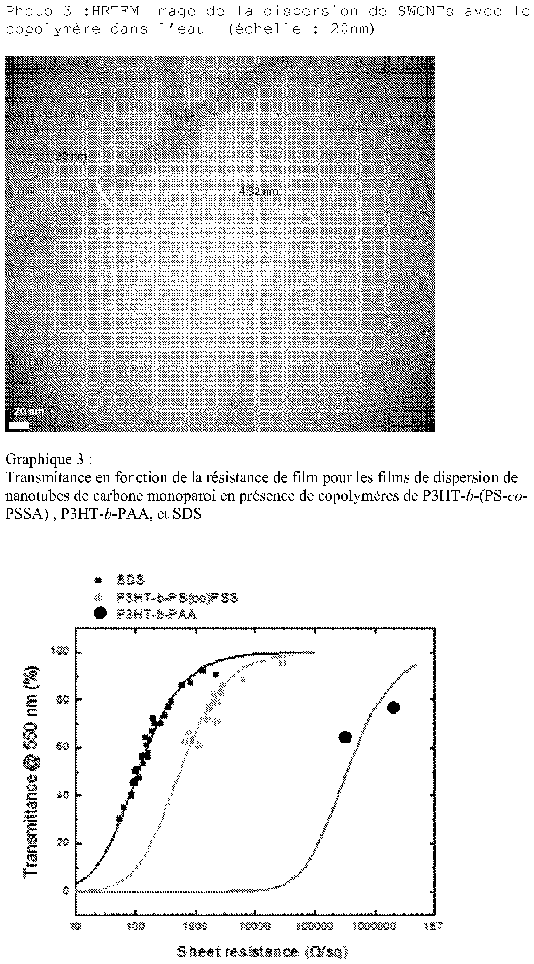

Des nanotubes de carbone mono-paroi non fonctionnalisés (Hanwha Nanotech, Corée) contenant 10 % en poids de catalyseur et 20 % en poids de graphite sont dispersés selon la méthode décrite dans l'exemple 3 et observé par microscopie à transmission haute résolution après cryobroyage. On observe dans la photo 3 une bonne dispersion de ces nanotubes et une fine couche à la surface des nanotubes de carbone correspondant au copolymère de l'invention.

### Exemple 7 (comparative) :

### Synthèse d'un copolymère à bloc Poly(3-hexyl-thiophène) - Poly (acide acrylique) :

Dans un premier temps on procède à la synthèse de Synthèse d'un copolymère à bloc Poly(3-hexyl-thiophène) - Poly(ter-butyle acrylate) par polymérisation radicalaire contrôlée par les nitroxides (NMP) par l'utilisation de Blocbuilder® disponible chez Arkema. Le macroinitiateur poly(3-hexyle-thiophène) terminé Blocbuilder® a été synthéthisé tel que décrit dans la publication de Mougnier et al., Journal of pol. Science Part A : Polymer chemistry. 2012, 50, 2463. La polymérisation du ter-butyle acrylate est effectuée en l'absence d'oxygène, dans le toluène à 120°C. Le copolymère Poly(3-hexyl-thiophène) - Poly (ter-butyle acrylate) est ensuite précipité au méthanol, puis est transformé en Poly(3-hexyl-thiophène) - Poly(acide acrylique) par hydrolyse dans un mélange 1.4 dioxane / d'acide tri-fluoro-acétique (TFA).

Typiquement, dans un ballon adapté, le macroinitiateur poly(3-hexyle-thiophène) terminé Blocbuilder® (1g, 0.2 mmol) est dissout dans 50 ml de toluène et mis sous agitation 1 heure à 40 °C. Ensuite, 36mmol de ter-butyle acrylate sont additionnées et le mélange est mis sous agitation durant 5 minutes. Le ballon est ensuite plongé dans un bain d'huile à 115°C sous agitation durant 5 heures. Ensuite le ballon est plongé dans un bain d'azote liquide pour stopper la polymérisation. Le copolymère à bloc est isolé par précipitation dans du méthanol froid, puis filtré et séché sous vide durant 24 heures et caractérisé par ¹H NMR et SEC dans le THF avec des étalons polystyrène.
LE copolymère à bloc est ensuite hydrolysé de la manière suivante : 0.05 mmol sont agité dans du choroforme 30 minutes à température ambiante sous azote dans un ballon à 3 tubulures. Après dissolution complète, on ajoute 0.5 ml de TFA. A ce mélange réactionnel, 3ml de 1,4 dioxane sont ajoutés. La réaction est mise au reflux durant 18 heures. Une seconde portion de 1.4 dioxane (5 ml) est additionnée et mise à reflux durant 18 heures. Le copolymère résultant est refroidit à l'ambiante , précipité au méthanol, séché et filtré. On le caractérise par ¹H NMR, FTIR et SEC dans le THF avec des étalons polystyrène. Il est soluble dans le THF et le chloroforme.

### Exemple 8 (comparaison des dispersions et films de nanotubes de carbone en présence de copolymères de l'invention et de copolymère Poly(3-hexyl-thiophène) - Poly(acide acrylique)).

Les dispersions et films sont réalisés selon les exemples 3 et 4 dans les mêmes conditions selon que l'on utilise les copolymères de l'invention ou le Poly(3-hexyl-thiophène) - Poly (acide acrylique).

On effectue des mesures de transmitance à 550 nm en fonction de la résistance du film (mesurée en Ω/sq). une référence de dispersion de nanotubes de carbone dans du dodécyle sufate de sodium (SDS) est également mesurée.

Comme on peut le voir sur le graphique 3, les copolymères de l'invention autorise une bien meilleure transmitance du film pour un résistance de film équivalent lorsque l'on utilise les copolymères de l'invention par rapport au copolymère Poly(3-hexyl-thiophène) - Poly(acide acrylique).

## Revendications

1. Composition comprenant au moins un copolymère à blocs soluble ou présentant une dispersion stable dans l'eau et présentant au moins un bloc constitué d'un polymère conjugué et au moins un bloc constitué d'un polymère poly-électrolyte de type styrène-styrène sulfonate.

2. Composition selon la revendication 1 dans laquelle le ou les copolymères à blocs sont du type di-blocs, tri-blocs, ou multi-blocs ou leur mélange, incluant l'homopolymère de chacun des blocs.

3. Composition selon la revendication 1 comprenant au moins copolymère di-bloc.

4. Composition selon la revendication 1 dans laquelle le polymère conjugué est dérivé du thiophène.

5. Composition selon la revendication 4 dans laquelle le dérivé du thiophène est un 3-alkyle-thiophène.

6. Composition selon la revendication 5 dans laquelle de dérivé du thiophène est le 3-hexyle thiophène .

7. Composition selon la revendication 1 selon laquelle le bloc poly-électrolyte présente une masse moléculaire en poids comprise entre 1000 et 500000 g/mole comme déterminée dans la description.

8. Composition selon la revendication 1 selon laquelle le bloc polymère conjugué présente une masse moléculaire en poids comprise entre 1000 et 50000 g/mole comme déterminée dans la description.

9. Utilisation d'une dispersion aqueuse comprenant un copolymère à bloc selon une des revendications 1 à 8 et une nanocharge dans les domaines du solaire photovoltaique, les dispositifs photoémetteurs ou photorécepteurs.

10. Utilisation selon la revendication 9 dans laquelle la nanocharge est choisie parmi les graphènes, fullerènes, nanotubes de carbone ou de leur combinaison.

11. Utilisation selon la revendication 11 dans laquelle la nanocharge est constituée de nanotubes de carbone.

12. Utilisation selon la revendication 11 dans laquelle la nanocharge est constituée de nanotubes de carbone multi-paroi.

## Patentansprüche

1. Zusammensetzung, enthaltend mindestens ein Blockcopolymer, das löslich ist oder eine stabile Dispersion in Wasser bildet und mindestens einen Block, der aus einem konjugierten Polymer besteht, und mindestens einen Block, der aus einem Polyelektrolyt-Polymer vom Styrol-Styrol-Sulfonat-Typ besteht, aufweist.

2. Zusammensetzung nach Anspruch 1, wobei das eine oder die mehreren Blockcopolymere Diblock-, Triblock- oder Multiblock-Blockcopolymere oder ein Gemisch davon sind, einschließlich des Homopolymers von jedem der Blöcke.

3. Zusammensetzung nach Anspruch 1, enthaltend mindestens ein Diblockcopolymer.

4. Zusammensetzung nach Anspruch 1, wobei das konjugierte Polymer ein Thiophenderivat ist.

5. Zusammensetzung nach Anspruch 4, wobei das Thiophenderivat ein 3-Alkylthiophen ist.

6. Zusammensetzung nach Anspruch 5, wobei das Thiophenderivat 3-Hexylthiophen ist.

7. Zusammensetzung nach Anspruch 1, wobei der Polyelektrolytblock eine gewichtsmittlere Molmasse zwischen 1.000 und 50.0000 g/mol aufweist, wie in der Beschreibung bestimmt.

8. Zusammensetzung nach Anspruch 1, wobei das konjugierte Blockpolymer eine gewichtsmittlere Molmasse zwischen 1.000 und 50.0000 g/mol aufweist, wie in der Beschreibung bestimmt.

9. Verwendung einer wässrigen Dispersion, enthaltend ein Blockcopolymer nach einem der Ansprüche 1 bis 8 und einen Nanofüllstoff, auf den Gebieten Photovoltaik, den lichtemittierenden oder lichtempfangenden Vorrichtungen.

10. Verwendung nach Anspruch 9, wobei der Nanofüllstoff ausgewählt ist aus Graphenen, Fullerenen, Kohlenstoff-Nanoröhrchen oder deren Kombination.

11. Verwendung nach Anspruch 10, wobei der Nanofüllstoff aus Kohlenstoff-Nanoröhrchen besteht.

12. Verwendung nach Anspruch 11, wobei der Nanofüllstoff aus mehrwandigen Kohlenstoff-Nanoröhrchen besteht.

## Claims

1. Composition comprising at least one block copolymer which is soluble or which exhibits a stable dispersion in water and which has at least one block consisting of a conjugated polymer and at least one block consisting of a polyelectrolyte polymer of styrene-styrene sulfonate type.

2. Composition according to Claim 1, wherein the block copolymer(s) is (are) of the diblock, triblock or multiblock type, or a mixture thereof, including the homopolymer of each of the blocks.

3. Composition according to Claim 1, comprising at least one diblock copolymer.

4. Composition according to Claim 1, wherein the conjugated polymer is a thiophene derivative.

5. Composition according to Claim 4, wherein the thiophene derivative is a 3-alkylthiophene.

6. Composition according to Claim 5, wherein the thiophene derivative is 3-hexylthiophene.

7. Composition according to Claim 1, wherein the polyelectrolyte block has a weight-average molecular weight of between 1000 and 500 000 g/mol as determined in the description.

8. Composition according to Claim 1, wherein the conjugated polymer block has a weight-average molecular weight of between 1000 and 50 000 g/mol as determined in the description.

9. Use of an aqueous dispersion comprising a block copolymer according to one of Claims 1 to 8 and a nanofiller, in the photovoltaic solar fields, or photoemitter or photoreceptor devices.

10. Use according to Claim 9, wherein the nanofiller is chosen from graphenes, fullerenes, carbon nanotubes, or in combination thereof.

11. Use according to Claim 10, wherein the nanofiller consists of carbon nanotubes.

12. Use according to Claim 11, wherein the nanofiller consists of multi-walled carbon nanotubes.
